(19) Europäisches Patentamt
European Patent Office
Office européen des brevets

(11) **EP 2 426 502 A1**

(12) **EUROPEAN PATENT APPLICATION**

(43) Date of publication:
**07.03.2012 Bulletin 2012/10**

(51) Int Cl.:
***G01R 31/34*** *(2006.01)*

(21) Application number: **10460035.8**

(22) Date of filing: **06.09.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **ABB Technology AG**
**8050 Zürich (CH)**

(72) Inventors:
• **Orman, Maciej, ul.**
**32-052 Radziszow (PL)**

• **Orkisz, Michal**
**30-076 Krakow (PL)**
• **Pinto, Cajetan**
**Brandra Reclamation, Mumbai 400 050 (IN)**

(74) Representative: **Chochorowska-Winiarska, Krystyna**
**ABB Sp. z o. o.,**
**Ul. Zeganska 1**
**04-713 Warszawa (PL)**

(54)     **A method for detecting rotor failure in an asynchronous motor**

(57)     The invention relates to a method for detecting rotor bar failure in an asynchronous motor, which is applicable to detecting failure in the squirrel cage bars in an asynchronous motor during its operation, without the need to interfere in the conditions of its operation. The inventive method uses measurement of the signals of current (I1, I2, I3) that supplies the stator winding in the asynchronous motor taken for at least one supply phase and an analysis of the current spectrum of discrete current signals (I1D, I2D, I3D) during the motor operation. The inventive method is characterized in that discrete current signals (I1D, I2D, I3D) are demodulated and the indicator of non-standardized level of bar damage ($A_{brb}$) is determined from the value of amplitudes ($I1_{DemA-brb}$, $I2_{DemA-brb}$, $I3_{DemA-brb}$) obtained for discrete signals after demodulation ($I1_{Dem}$, $I2_{Dem}$, $I3_{Dem}$), and then the number of broken bars ($B_{cond}$) is provisionally calculated according to the following relation:

$$B_{cond} = \frac{A_{brb}}{I_R} R ,$$

where:
$A_{brb}$ - is an arithmetic mean calculated from selected values of amplitude ($I1_{DemA-brb}$, $I2_{DemA-brb}$, $I3_{DemA-brb}$),
R - is the number of the rotor bars,
$I_R$ - is the rotor current calculated on the basis of the rated parameters of the motor and the root-mean-square value of current $I_{rms}$.

Next, the result ($B_{cond}$) obtained from the calculations, after rounding to an integer value, is accepted as the final result meaning the number of broken rotor bars in the asynchronous motor.

Fig 1

**Description**

The invention relates to a method for detecting rotor bar failure in an asynchronous motor, which is applicable to detecting failure in the squirrel cage bars in an asynchronous motor during its operation, without the need to interfere in the conditions of operation.

So far, the methods for diagnosing the technical condition of the cage bars in an asynchronous motor have been based on the measurement of the alternating current of the stator winding. There is a commonly known method for detecting the condition of rotor cage bars by examining the spectrum of the alternating current of the stator winding and detecting the amplitudes of sidebands occurring in this spectrum. However, this method is insufficient for small motor loads. Small load causes small slip, which leads to difficulties in distinguishing sidebands from the power supply frequency. Moreover, a comparison of sideband amplitudes expressed in decibels with the generally accepted threshold value of 42dB, which means a failure of one bar, may be troublesome due to the variation of sideband amplitudes occurring with motor load.

US patent description 7,081,760 reveals a method for detecting the condition of the rotor bars in an asynchronous motor. This method consists in measuring current and voltage values during the operation of the motor. Then, the shaft oscillation frequency amplitude is determined on the basis of the vector of the asynchronous motor condition determined on the basis of the measured current and voltage values. The level of shaft oscillation increases with an increase in the number of broken rotor bars. The crucial problem in the presented solution is the necessity to measure the voltage. In practical applications voltage measurement is often made impossible by the lack of suitable measuring instruments. In US patent description 7,081,760, it is necessary to measure current and voltage signals, which requires a simultaneous measurement of six signals and their processing, hence this method is not practical for checking the condition of rotor bars in an asynchronous motor in cases where it is not possible to measure the voltage.

The essence of the inventive method is that after the measurement of the signals of the current (11, 12, 13) that supplies the winding of the asynchronous motor stator taken for at least one supply phase, and after an analysis of the current spectrum of discrete current signals ($I1_D$, $I2_D$, $13_D$), demodulation of individual discrete current signals ($I1_D$, $12_D$, $13_D$) is performed and the indicator of the non-standardized level of bar damage $A_{brb}$ is determined as the arithmetic average of the values of the amplitude ($I1_{DemA^-brb}$, $I2_{DemA^-brb}$, $I3_{DemA^-brb}$) obtained for the individual discrete signals after the demodulation ($I1_{Dem}$, $I2_{Dem}$, $I3_{Dem}$), and next the number of broken bars $B_{cond}$ is provisionally calculated according to the following relation:

$$B_{cond} = \frac{A_{brb}}{I_R} R \,,$$

where:

$A_{brb}$ - is an arithmetic mean calculated from selected values of amplitude ($I1_{DemA-brb}$, $I2_{DemA-brb}$, $I3_{DemA-brb}$),
R - is the number of the rotor cage bars,
$I_R$ - is the rotor current calculated from the rated parameters of the motor and the root-mean-square value of the current $I_{rms}$.

And next the result $B_{cond}$ obtained from the calculations, after rounding to an integer, is assumed to be the final result indicating the number of broken bars of the rotor cage in the asynchronous motor.

Preferably, the values of individual amplitudes ($I1_{DemA-bb}$, $I2_{DemA-brb}$, $I3_{DemA-brb}$) obtained for discrete signals after demodulation ($I1_{Dem}$, $I2_{Dem}$, $I3_{Dem}$) are obtained as the values of the amplitude vectors ($I1_{DemA}$, $I2_{DemA}$, $13_{DemA}$) obtained as a result of demodulation of discrete current signals ($I1_D$, $I2_D$, $I3_D$) which correspond to the individual values of frequency vectors ($I1_{Demw}$, $I2_{Demw}$, $I3_{Demw}$) selected as the nearest ones to the bar failure frequency $f_{brb}$.

Preferably the bar failure frequency $f_{brb}$ is calculated from the following relation:

$$f_{brb} = 2 f_a s \,,$$

where:

$f_a$ is the supply frequency,
s is the slip of the asynchronous motor.

The essence of the computer program for detecting rotor bar failure in an asynchronous motor, which is loadable to and executable in a computer device (6), is that during its run it executes the method according to claims 1-3.

The advantage of the inventive solution is a considerable reduction in the time of measurement as compared with the classic methods of sideband amplitude detection which require a relatively long time of measurement of the signal of the alternating current of the stator windings. Too short time of measurement causes that sideband amplitudes are not distinguishable from supply frequency amplitudes. In the presented inventive solution failure in the rotor cage bars in an asynchronous motor is detected by measuring the alternating current of the stator windings, and there is no need to measure the supply voltage. An additional advantage of the inventive solution is a constant indicator obtained only on the basis of the measurement of current signals, informing about the degree of damage to the rotor cage bars in relation to variable load. In known methods, for different motor load different values of the indicators relating to the damage to rotor cage bars are obtained, which makes it considerably difficult to analyze the actual degree of damage.

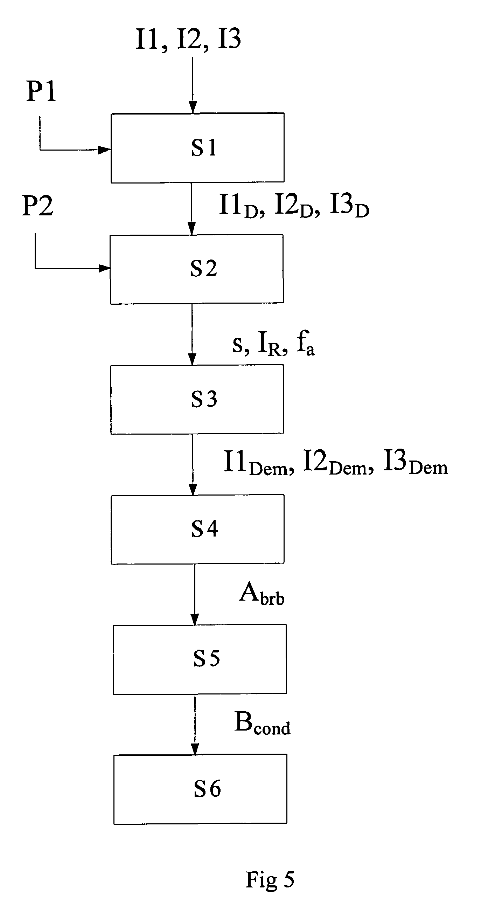

The subject of the invention is presented as an embodiment in the drawing where fig. 1 shows a block diagram of the system for the realization of the invention, fig.2 - a fragment of the spectrum W1 of a discrete current signal $I1_D$ for one current phase after transformation from the time domain to the frequency domain, fig.3 - a diagram of the discrete signal after demodulation $I1_{Dem}$ for one current phase, fig.4 - a fragment of the spectrum W1 of the discrete signal after demodulation $I1_{Dem}$ for one current phase after transformation from the time domain to the frequency domain, and fig. 5 - a flow chart illustrating the method for the realization of the invention.

The measuring system for the realization of the method according to the invention is connected to a three-phase source of alternating current supply 1 connected with an asynchronous motor 3 by supply cables 2. The supply cables 2 are connected with a measuring device 4 containing an analog to digital converter 5 which is connected with a computer processing device 6 containing a processor 7 and a processing module 8, a demodulation module 9 and a data storage module 10, which are suitable for the realization of the method according to the invention. The computer processing device 6, through the measuring device 4, is coupled with a device 11 for visualizing the results obtained by executing the inventive method. In the presented embodiment of the invention, the measuring device 4 is integrated with the computer device 6, but the measuring device and the computer device may be separate devices, which is not shown in the drawing. In such case the device 11 for visualizing the results is directly or remotely connected with the computer device 6.

The method according to the invention is executed in steps S 1- S6.

Step S1

In step S1 the signals of the current 11, 12, 13 of the alternating current that supplies the stator winding for at least one current phase of the asynchronous motor 3 are measured, which signals are then converted to discrete current signals $I1_D$, $I2_D$, $I3_D$ in an analog to digital converter 5 to which constant parameters P1 are supplied, which parameters characterize the process of conversion of analog signals to discrete signals, i.e. the sampling rate Fs and the length of the signal subjected to conversion $T_L$. The sampling rate Fs defines the number of samples per second taken from the signals of current I1, I2, I3. Usually the minimum sampling rate is 1 kHz and this is the default setting. Signal length $T_L$ defines the length of the signals of the current I1, I2, I3 taken for analog to digital conversion. In the embodiment of the inventive method the minimum value of the signal length $T_L$ is 2s.

The discrete current signals $I1_D$, $I2_D$, $I3_D$ are automatically transmitted to the processing module 8 implementing in the computer device 6.

Step S2

In step S2 the following data are supplied to the data storage module 10 implemented in the computer device 6: the constant rated data P2 describing the parameters of the asynchronous motor 3, i.e.: rated current $I_n$, rated voltage $U_n$, rated power factor $pf_n$, rated power $P_n$, rated speed $f_{rnom}$, rated slip $s_n$, the number of the cage bars R and the number of the poles $p$ of the asynchronous motor 3, while the rated slip $s_n$ can be calculated on the basis of supplied constant parameters in the course of the computational processing during the execution of the inventive method.

In this step, in the processing module 8 of the computer device 6, the quadratic mean value RMS1, RMS2, RMS3 is then calculated for individual phases for the discrete current signals $I1_D$, $I2_D$, $I3_D$ respectively, and then from the quadratic mean values RMS1, RMS2, RMS3 the arithmetic average which is the root-mean-square current $I_{rms}$ is calculated. In a case where only one phase of the discrete current signal is used, e.g. $I1_D$, this value is the quadratic mean RMS1.

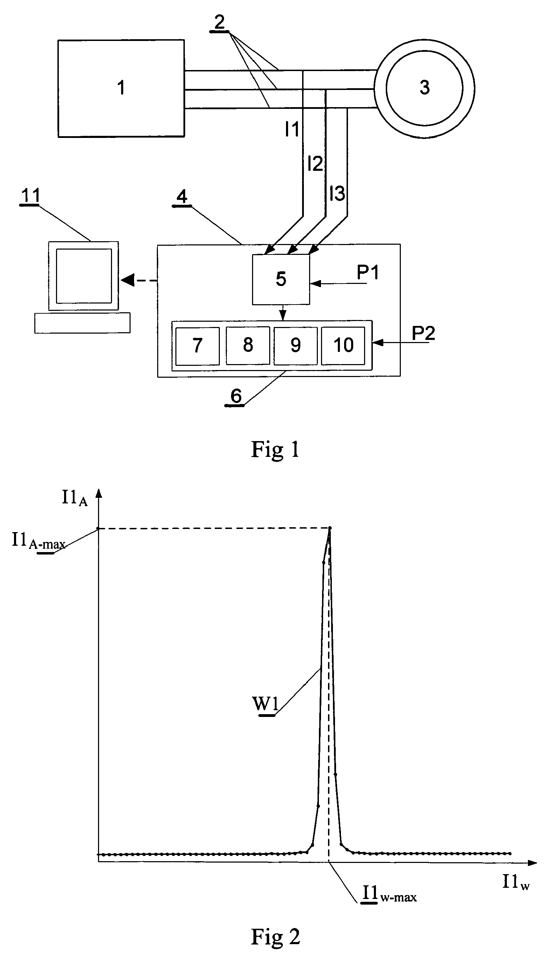

Next, individual discrete current signals $I1_D$, $I2_D$, $I3_D$ are transformed from the time domain to the frequency domain by means of the fast Fourier transform FFT. The discrete current signals $II_D$, $I2_D$, $I3_D$, after transformation, form a spectrum W1, W2, W3, which is formed of frequency vectors $I1_w$, $12_w$, $13_w$ and the corresponding amplitude vectors $I1_A$, $I2_A$, $I3_A$, which is shown in fig. 2 for one current phase. Then, from among the individual amplitude vectors $I1_A$, $I2_A$,

I3$_A$ their maximum value is selected, in fig. 2 marked I1$_{A\text{-max}}$ , and for these values the value corresponding to it is read off from the frequency vector I1$_w$, I2$_w$, I3$_w$ respectively, which in fig. 2 is marked I1$_{w\text{-max.}}$. Then, from so selected values of the frequency vector I1$_{w\text{-max}}$, I2$_{w\text{-max}}$, I3$_{w\text{-max}}$ a quadratic mean, which is presented as supply frequency f$_a$ , is calculated. In a case where only one current phase is used, for example from spectrum W1, the supply frequency f$_a$ is the value of the frequency vector I1$_{w\text{-max}}$. From the calculated values, i.e. the root-mean-square current $I_{rms}$ and the supply frequency f$_a$ , the slip of the motor s is then calculated, according to this relation:

$$ s = \left[ 1 - \sqrt{1 - 4\frac{I_{rms}}{I_n} \cdot pf \cdot \frac{\sqrt{3}I_n U_n}{P_n} \cdot \frac{p \cdot f_{rnom}}{2f_a} \cdot s_n} \right] / 2 , \qquad (1), $$

where : P$_n$, I$_n$, U$_n$, f$_{rnom}$, p, s$_n$ are the rated data P2 of the motor parameters taken from the data storage module 10 to the processing module 8 and pf is the power factor. Which can be calculated as:

$$ pf = 0.01 + \cos\sqrt{\arcsin(\frac{I_n}{I_{rms}} \cdot (1 - pf_n{}^2))} , \qquad (2), $$

Moreover, in this step, in the processing module 8, using the rated data P2 of the motor parameters taken from the data storage module 10, the intensity of rotor current $I_R$ is calculated according to this relation:

$$ I_R = \sqrt{I_0{}^2 + I_{rms}{}^2 - 2I_0 I_{rms} \cos\left( \frac{86\pi}{180} - \arccos(pf) \right)} \qquad (3), $$

where pf is the power factor and $I_0$ is magnetizing current which is calculated from this relation:

$$ I_0 = \frac{I_n(1 - pf_n)}{0.41} , \qquad (4), $$

where:

I$_n$, U$_n$, pf$_n$ are the rated data P2 of the motor parameters taken from the data storage module 10 to the processing module 8.

The calculated values of f$_a$, I$_R$, s are used in the next steps.

Step S3

In step S3, in the demodulation module 9, individual discrete current signals I1$_D$, I2$_D$, I3$_D$ are demodulated, the result being discrete signals after demodulation I1$_{Dem}$, I2$_{Dem}$, I3$_{Dem}$.

In the embodiment of the inventive method, demodulation of discrete current signals I1$_D$, I2$_D$, I3$_D$ is performed as follows.

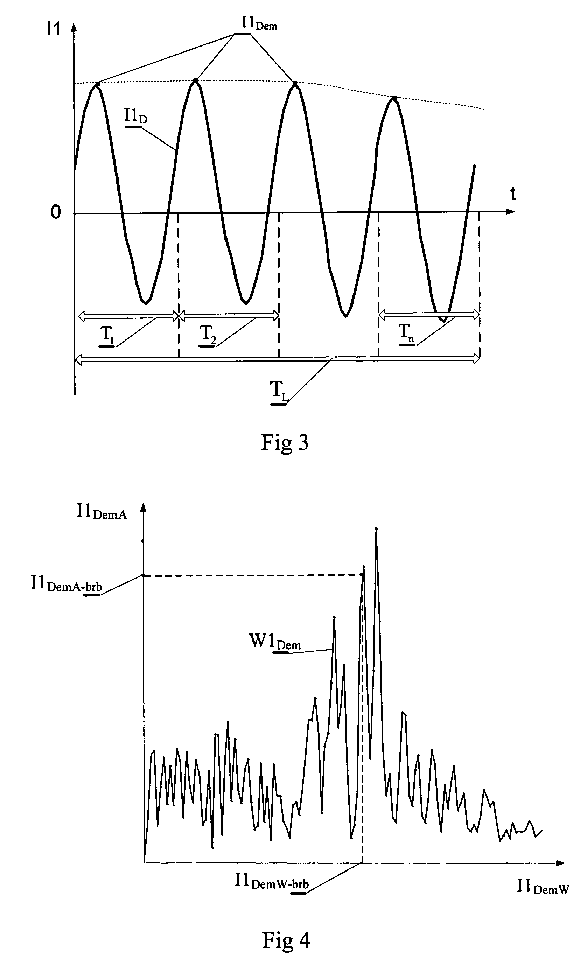

Each of the discrete current signals I1$_D$, I2$_D$, I3$_D$ is divided into n intervals of equal length, where n is a natural number, which form sequences of intervals T1$_1$ ...T1$_n$, T2$_1$...T2$_n$, T3$_1$,...T3$_n$ respectively, which is shown in fig. 3 for a discrete current signal I1$_D$ for one phase. The selection of the number of the presented intervals consists in the fact that their number is the product of the value of the signal length T$_L$ and the supply frequency f$_a$, rounded to an integer. Next, for individual sequences of intervals T1$_1$, ... T1$_n$, T2$_1$...T2$_n$, T3$_1$ ...T3$_n$, the amplitude of a sinusoid is calculated, which sinusoid is adjusted in a known way to all elements of the given sequence of intervals which form amplitude sequences in the form of discrete signals after demodulation I1$_{Dem}$, I2$_{Dem}$, I3$_{Dem}$, which is shown in fig. 3 for one current phase of the discrete current signal $I1_D$.

Step S4

In step S4, in the processing module 8, failure frequency $f_{brb}$ is calculated for individual signals after demodulation $I1_{Dem}$, $I2_{Dem}$, $I3_{Dem}$ which correspond to the frequencies of sidebands for individual discrete current signals $I1_D$, $I2_D$, $I3_D$ before demodulation. The bar failure frequency $f_{brb}$ is calculated according to this relation:

$$f_{brb} = 2f_a s , \tag{5},$$

where:

s is the slip of the motor calculated in step 2,
$f_a$ is the supply frequency calculated in step 2.

Next, individual discrete signals after demodulation $I1_{Dem}$, $I2_{Dem}$, $I3_{Dem}$ respectively, are transformed from the time domain to the frequency domain by means of the fast Fourier transform FFT in order to obtain the spectrum of the signal after demodulation. The signals $I1_{Dem}$, $I2_{Dem}$, $I3_{Dem}$ after the FFT transformation form spectrums $W1_{Dem}$, $W2_{Dem}$, $W3_{Dem}$ consisting of frequency vectors $I1_{Demw}$, $I2_{Demw}$, $I3_{Demw}$ and the corresponding amplitude vectors $II_{DemA}$, $I2_{DemA}$, $I3_{DemA}$. An example of a signal for one of the phases has been shown in fig. 4 as $W1_{Dem}$. Next, values which are equal to the failure frequency $f_{brb}$ are selected from among frequency vectors $I1_{Demw}$, $I2_{Demw}$, $I3_{Demw}$, which values are marked $I1_{Demw-brb}$ in fig. 4, and the corresponding values from the amplitude vectors $I1_{DemA}$, $I2_{DemA}$, $I3_{DemA}$, in fig. 4 marked $I1_{DemA-brb}$. If none of the frequency vector values is equal to the failure frequency $f_{brb}$, the value nearest to the failure frequency $f_{brb}$ is selected.
Then, the arithmetic mean is calculated from the selected values of amplitudes $I1_{DemA-brb}$, $I2_{DemA-brb}$, $I3_{DemA-brb}$, which is the indicator of the non-standardized level of damage to the bars $A_{brb}$ of the asynchronous motor 3 rotor cage. If only one current phase is used, the indicator of the non-standardized level of bar damage $A_{brb}$ is the value of one of the amplitude vectors, for example $I1_{DemA-brb}$.

Step S5

In step S5, in the processing module 8, the number of broken rotor cage bars is provisionally calculated according to this relation:

$$B_{cond} = \frac{A_{brb}}{I_R} R , \tag{6},$$

where $I_R$ is the rotor current calculated in step 2,
and R is the number of the cage bars taken to the processing module 8 from the data storage module 10, supplied in the parameter group P2.

Next, the result obtained in the relation, after rounding to an integer value, is accepted as the final result meaning the number of broken bars of the rotor cage in the asynchronous motor.
If the calculated value $B_{cond}$ is equal to an integer, this means that this integer is the number of broken bars of the asynchronous motor cage.

Step 6

In step S6, the results obtained in step 5 are visualized by means of the visualization device 11 using a known method.
The embodiment presents the method for detecting rotor bar failure in an asynchronous motor using three-phase power supply and measurements for three current phases, though fig. 2, 3 and 4 in the drawing apply to the realization of the invention for only one current phase supplied with current I1. The invention is realized analogously for two current phases, where the actions for the calculation of arithmetic means for the presented data are performed, whereas if only one phase is used, the actions for the calculation of arithmetic means are omitted, which is understandable.

**Claims**

1. A method for detecting rotor bar failure in an asynchronous motor, using measurement of the signals of current (11, 12, 13) that supplies the stator winding in the asynchronous motor taken for at least one supply phase, and including an analysis of the current spectrum of discrete current signals ($I1_D$, $I2_D$, $I3_D$) during the motor operation, **characterized in that** a demodulation of individual discrete current signals ($11_D$, $I2_D$, $I3_D$) is performed and the indicator of non-standardized level of bar damage ($A_{brb}$) is determined from the value of amplitude ($I1_{DemA-brb}$, $I2_{DemA-brb}$, $I3_{DemA-brb}$) obtained for individual discrete signals after demodulation ($I1_{Dem}$, $I2_{Dem}$, $I3_{Dem}$), and then the number of broken bars ($B_{cond}$) is provisionally calculated according to the following relation:

$$B_{cond} = \frac{A_{brb}}{I_R} R \,,$$

where:

$A_{brb}$ - is an arithmetic mean calculated from selected values of amplitude ($I1_{DemA-brb}$, $I2_{DemA-brb}$, $I3_{DemA-brb}$),
R - is the number of the rotor bars,
$I_R$ - is the rotor current calculated on the basis of the rated parameters of the motor and the root-mean-square value of current $I_{rms}$,

and then the value of the result ($B_{cond}$) obtained from the provisionally calculations is rounding to an integer value, which is accepted as the final result meaning the number of broken rotor bars in the asynchronous motor.

2. A method according to claim 1, **characterized in that** the values of individual amplitudes ($I1_{DemA-bb}$, $I2_{DemA-brb}$, $I3_{DemA-brb}$) obtained for discrete signals after demodulation ($I1_{Dem}$, $I2_{Dem}$, $I3_{Dem}$) are obtained as the values of amplitude vectors ($I1_{DemA}$, $I2_{DemA}$, $I3_{DemA}$) obtained as a result of demodulation of discrete current signals ($I1_D$, $I2_D$, $I3_D$) which correspond to individual values of frequency vectors ($I1_{Demw}$, $I2_{Demw}$, $I3_{Demw}$) selected as those which are nearest to the bar failure frequency ($f_{brb}$).

3. A method according to claim 2, **characterized in that** the bar failure frequency ($f_{brb}$) is calculated from the following relation:

$$f_{brb} = 2f_a s \,,$$

where:

$f_a$ - is the supply frequency,
s - is the slip of the asynchronous motor.

4. A computer program for detecting rotor bar failure in an asynchronous motor, which is loadable to and executable in a computer device (6), **characterized in that** during its run it executes the method according to claims 1-3.

Fig 1

Fig 2

Fig 3

Fig 4

I1, I2, I3

P1

S1

I1$_D$, I2$_D$, I3$_D$

P2

S2

s, I$_R$, f$_a$

S3

I1$_{Dem}$, I2$_{Dem}$, I3$_{Dem}$

S4

A$_{brb}$

S5

B$_{cond}$

S6

Fig 5

Europäisches
Patentamt
European
Patent Office
Office européen
des brevets

# EUROPEAN SEARCH REPORT

Application Number

EP 10 46 0035

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RAZIK ET AL.: "On the Monitoring of the Defects of Squirrel Cage Induction Motors", IEEE POWER TECH CONFERENCE PROCEEDINGS, vol. 2, 23 June 2003 (2003-06-23), - 26 June 2003 (2003-06-26), pages 1-6, XP002619680, Bologna DOI: 10.1109/PTC.2003.1304327 ISBN: 0-7803-7967-5 [retrieved on 2011-02-01] * abstract; figure 1; table 1 * * page 2, right-hand column, lines 20-22 * * page 3, line 49 - page 4, line 7 * * page 1, lines 22-25 * * page 4, lines 9-25 * ----- | 1-4 | INV. G01R31/34 |
| A | AREZKI MENACER ET AL: "Effect of the Position and the Number of Broken Bars on Asynchronous Motor Stator Current Spectrum", POWER ELECTRONICS AND MOTION CONTROL CONFERENCE, 2006. EPE-PEMC 2006. 12TH INTERNATIONAL, IEEE, PISCATAWAY, NJ, USA, 30 August 2006 (2006-08-30), pages 973-978, XP031421744, ISBN: 978-1-4244-0121-5 * the whole document * ----- -/-- | 1-4 | |
|  |  |  | TECHNICAL FIELDS SEARCHED (IPC) |
|  |  |  | G01R |

The present search report has been drawn up for all claims

| Place of search | Date of completion of the search | Examiner |
|---|---|---|
| Munich | 1 February 2011 | Dogueri, Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

## EUROPEAN SEARCH REPORT

**Application Number**

EP 10 46 0035

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CALIS ET AL: "Experimental study for sensorless broken bar detection in induction motors", ENERGY CONVERSION AND MANAGEMENT, ELSEVIER SCIENCE PUBLISHERS, OXFORD, GB, vol. 49, no. 4, 22 February 2008 (2008-02-22), pages 854-862, XP022494464, ISSN: 0196-8904, DOI: DOI:10.1016/J.ENCONMAN.2007.06.030 * the whole document * | 1-4 | |
| A | PARLOS A G ET AL: "Sensorless detection of mechanical faults in electromechanical systems", MECHATRONICS, PERGAMON PRESS, OXFORD, GB, vol. 14, no. 4, 1 May 2004 (2004-05-01), pages 357-380, XP004486006, ISSN: 0957-4158, DOI: DOI:10.1016/S0957-4158(03)00065-5 * the whole document * | 1-4 | |
| A,D | US 2006/006879 A1 (MIRAFZAL BEHROOZ [US] ET AL MIRAFZAL BEHROOZ [US] ET AL) 12 January 2006 (2006-01-12) * abstract; figures 1,2 * | 1-4 | **TECHNICAL FIELDS SEARCHED (IPC)** |

The present search report has been drawn up for all claims

| Place of search | Date of completion of the search | Examiner |
|---|---|---|
| Munich | 1 February 2011 | Dogueri, Kerem |

EPO FORM 1503 03.82 (P04C01)

**EP 2 426 502 A1**

## ANNEX TO THE EUROPEAN SEARCH REPORT
## ON EUROPEAN PATENT APPLICATION NO.

EP 10 46 0035

This annex lists the patent family members relating to the patent documents cited in the above-mentioned European search report.
The members are as contained in the European Patent Office EDP file on
The European Patent Office is in no way liable for these particulars which are merely given for the purpose of information.

01-02-2011

| Patent document cited in search report | Publication date | Patent family member(s) | Publication date |
|---|---|---|---|
| US 2006006879 A1 | 12-01-2006 | NONE | |

EPO FORM P0459

For more details about this annex : see Official Journal of the European Patent Office, No. 12/82